# EUROPEAN PATENT SPECIFICATION

(11) **EP 0 439 634 B1**
(45) Date of publication and mention of the grant of the patent: **18.12.1996**
(21) Application number: 90101402.7
(22) Date of filing: 24.01.1990
(51) Int. Cl.: H01L 29/92, H01L 21/82

(54) **Method of manufacturing a semiconductor device including a trench capacitor**
Verfahren zur Herstellung eines Halbleiterbauelementes mit einer Grabenkapazität
Procédé pour la fabrication d'un dispositif à semiconducteur ayant une capacité en forme de tranchée

(43) Date of publication of application: 07.08.1991
(73) Proprietor: KABUSHIKI KAISHA TOSHIBA, Kawasaki-shi (JP)
(72) Inventor: Yamamoto, Tadashi, c/o Intellectual Property Div., Minato-ku, Tokyo 105 (JP); Kohyama, Yusuke, c/o Intellectual Property Div., Minato-ku, Tokyo 105 (JP); Tanaka, Takeshi, c/o Intellectual Property Div., Minato-ku, Tokyo 105 (JP)
(74) Representative: Lehn, Werner, Dipl.-Ing.

(56) References cited:
- GB-A- 2 138 207
- JAPANESE JOURNAL OF APPLIED PHYSICS, SUPPLEMENTS.15th conf. 1983, TOKYO JA pages 253 - 256; T. MORIE et al: "Depletion trench capacitor cell"
- IEEE CIRCUITS AND DEVICES MAGAZINE. vol. 5, no. 1, January 1989, NEW YORK US pages 27 - 36; N. C. C. LU: "Advanced cell structures for dynamic RAMs"

## Description

The present invention relates to a method of manufacturing a semiconductor device and, more particularly, to a method of manufacturing a semiconductor device including a trench capacitor and a MOS transistor.

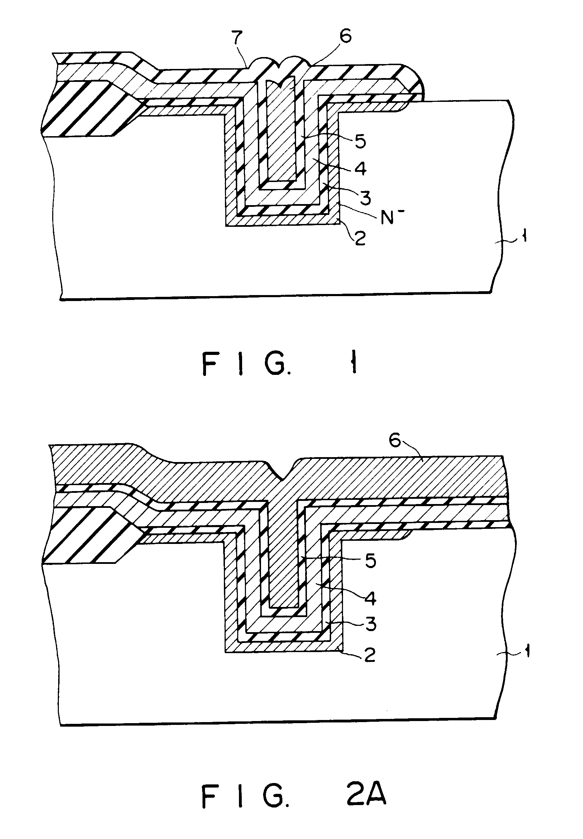

In the field of a semiconductor integrated circuit, a trench capacitor is well-known as a capacitor capable of achieving a large capacity in a small area. Fig. 1 is a cross-sectional view showing a conventional typical structure of the trench capacitor.

In Fig. 1, reference numeral 1 denotes a P-type semiconductor substrate, 2 indicates an N-type diffusion layer, 3 and 5 show insulating films, 4 and 6 indicate polysilicon layers, and 7 devotes an interlayer insulating film. Diffusion layer 2 and polysilicon layer 4 serve as both electrodes of the trench capacitor, and insulating film 3 serves as a dielectric film of the trench capacitor. polysilicon layer 6 is embedded in a groove to flatten the surface of a semiconductor body and is electrically insulated from polysilicon layer 4 by insulating film 5.

Referring to Figs. 2A to 2C, an explanation will be given of a manufacturing process in the case where polysilicon layer 6 is embedded into the groove.

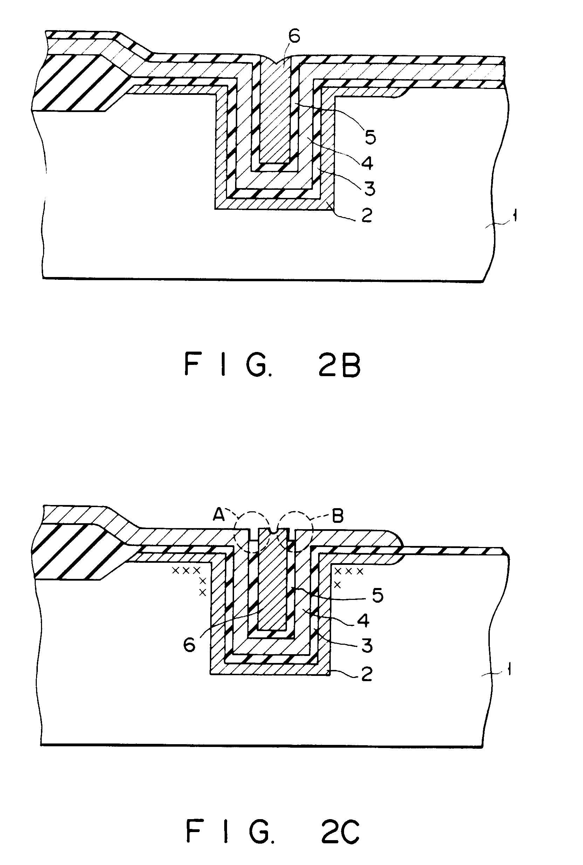

As illustrated in Fig. 2A, insulating film 5 is formed on polysilicon layer 4 and then polysilicon layer 6 is formed on the entire surface of insulating film 5 so as to fill up the groove. As shown in Fig. 2B, etching is performed, using insulating film 5 as a stopper of the etching, so as to make polysilicon layer 6 remain only in the groove. Next, insulating film 5 formed on the surface of polysilicon layer 4 is removed by wet etching, and then polysilicon layer 4 serving as a capacitor electrode is patterned. when insulating film 5 is removed by the wet etching, however, the surface portions of insulating film 5 between polysilicon layers 4 and 6 are over-etched, as shown by broken lines A and B in Fig. 2C.

As illustrated in Fig. 2C, therefore, not only the surfaces of polysilicon layers 4 and 6 but also the sides thereof are exposed. If polysilicon layers 4 and 6 are thermally oxidized to form an interlayer insulating film in this state, a stress is laterally applied to polysilicon layers 4 and 6, and a strong stress is caused in the regions represented by broken lines A and B in Fig. 2C. The stress degrades the withstanding voltage of insulating film 3 and reduces the reliability of the trench capacitor. As a result, defective crystals (shown by x) are easy to occur in the vicinity of the groove in substrate 1 by the stress applied to polysilicon layers 4 and 6. These defective crystals cause a leak or the like to be generated.

Furthermore, the conventional method of manufacturing the semiconductor device requires a manufacturing step of forming insulating film 5 as a stopper when polysilicon layer 6 is removed by etching, and a manufacturing step of removing insulating film 5 for patterning of polysilicon layer 4. The manufacturing steps are thus complicated.

The GB-A-2 138 207 discloses a semiconductor memory device and a method of manufacture thereof.

According to this document it is intended to reduce a leak current from a capacitor cell to a substrate and adjacent cells in a buried Stacked Capacitor (STC) cell. The buried STC structure is achieved by coating the innner walls of a trench with an insulation film.

This known method comprises the steps of selectively etching semiconductor substrate to form a groove therein, forming a first layer of a conductivity type on the sides and the bottom of said groove, forming a second layer of an insulation type along the inner surface of said groove, forming a third layer of a conductivity type along the inner surface of said groove and on the upper surface of said second layer, forming a fourth layer of an insulation type which covers said third layer, forming a fifth layer on said fourth layer so as to fill up said groove, etching said fifth layer so as to remain only in said groove and forming a sixth layer of an insulation type on said fifth layer.

From JAPANESE JOURNAL OF APPLIED PHYSICS, SUPPLEMENTS. 15th conf. 1983, TOKYO JA pages 253 - 256 it is known to provide a trench capacitor where one electrode is formed by diffusion of impurities into the trench.

It is accordingly an object of the present invention to provide a method of manufacturing a semiconductor device comprising a trench capacitor and a MOS transistor wherein those locations of stress are avoided, a fine insulation is achieved between a capacitor electrode of the trench capacitor and the gate electrode of the MOS transistor, and the manufacturing steps are simplified.

This object is solved according to independent claim 1.

Preferred embodiments are listed in the dependent claims.

According to the manufacturing method of the present invention, since the second conductive layer is patterned to form the capacitor electrode and then the interlayer insulating film is formed, the latter need not be removed for the patterning of the second conductive layer. For this reason, unlike the conventional device, the sides of the buried layer embedded in the groove are not exposed and only the surface thereof is exposed. Even though the buried layer is thermally oxidized to form the oxide film, the buried layer is only oxidized from the top and accordingly no stress is applied to the buried layer, thereby suppressing the degradation of the withstanding voltage of the trench capacitor and the generation of defective crystals. Since the interlayer insulating film functions as both a stopper of the etching performed to leave the buried layer only in the groove and an interlayer insulating film, it is unnecessary to form an insulating film exclusively for the stopper of the etching and it is possible to simplify the manufacturing steps.

Additional objects and advantages of the invention will be set forth in the description which follows, and in part will be obvious from the description, or may be learned by practice of the invention. The objects and advantages of the invention may be realized and obtained by means of the instrumentalities and combinations particularly pointed out in the appended claims.

This invention can be more fully understood from the following detailed description when taken in conjunction with the accompanying drawings, in which:

The accompanying drawings, which are incorporated in and constitute a part of the specification, illustrate a presently preferred embodiment of the invention, and together with the general description given above and the detailed description of the preferred embodiment given below, serve to explain the principles of the invention.
Fig. 1 is a cross-sectional view showing a structure of a conventional trench capacitor;
Figs. 2A to 2C are cross-sectional views showing conventional steps of manufacturing the trench capacitor shown in Fig. 1; and
Figs. 3A to 3H are cross-sectional views showing steps of manufacturing a semiconductor device including a trench capacitor according to an embodiment of the present invention.

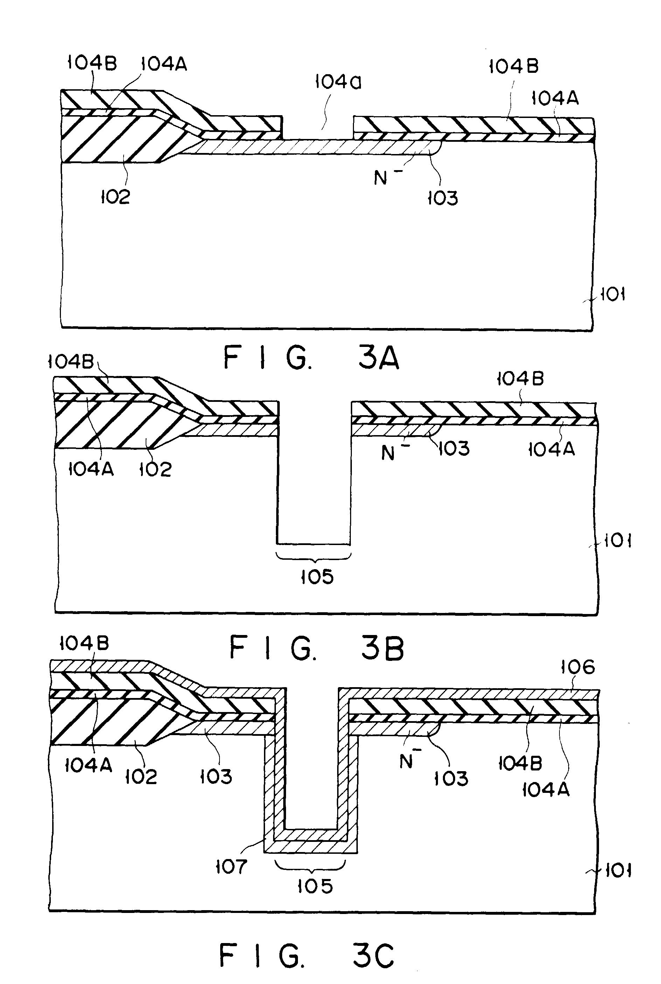

A method manufacturing a semiconductor device having a memory cell of a one-transistor and one-capacitor type according to an embodiment of the present invention will be described with reference to accompanying Figs. 3A to 3H.

As shown in Fig. 3A, field oxide film 102 for element isolation is formed on the surface of P-type silicon substrate 101 by the LOCOS method. Arsenic is by the photolithography technique and ion implantation technique to form N⁻-type diffusion layer 103 having a thickness of 0.2 to 0.25 µm and an impurity concentration of about 1 × 10¹⁹/cm³. Si₃N₄ film 104A of 50 to 100 nm (500 to 1000 Å) in thickness is deposited on substrate 101 by the LP-CVD method and then SiO₂ film 104B of 500 to 600 nm (5000 to 6000 Å) is deposited on Si₃N₄ film 104A by the CVD method. Opening 104a is formed in predetermined regions of Si₃N₄ film 104A and CVD-SiO₂ film 104B. Using CVD-SiO₂ film 104B as a mask, substrate 101 is etched by, e.g., the RIE (reactive ion etching) technique to form groove 105 having a depth of about 3 µm, as shown in Fig. 3B.

As illustrated in Fig. 3C, for example, PSG film 106 of about 100 nm (1000 Å) is deposited, as a diffusion source of N-type impurities, all over the surface of the device including the inner surface of the groove 105. PSG film 106 is thermally treated and thus N-type impurities are diffused into substrate 101, thereby forming N-type diffusion layer 107 along the bottom and the sides of groove 105.

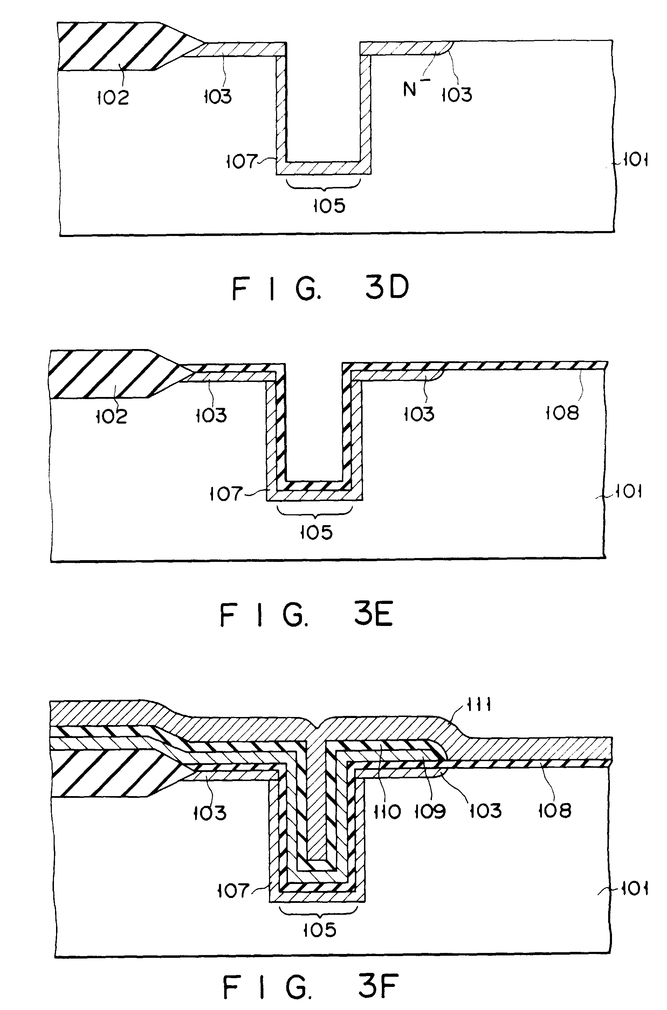

As illustrated in Fig. 3D, PSG film 106 and CVD-SiO₂ film 104B are removed by wet etching using, e.g., hydrofluoric acid, and then Si₃N₄ film 104A is removed by wet etching using, e.g., hot phosphoric acid. As shown in Fig. 3E, thermal oxidization is performed to form oxide film 108 having a thickness of 100 to 200 Å on the inner surface of groove 105 and on that of substrate 101.

As illustrated in Fig. 3F, polysilicon film 109 of 2000 to 4000 Å in thickness is deposited on oxide film 108 by the LP-CVD method and it is doped with N-type impurities such as phosphorus, and then polysilicon film 109 is patterned to form a capacitor electrode. After that, polysilicon film 109 is thermally oxidized to form interlayer insulating film 110 of 100 to 200 nm (1000 to 2000 Å) in thickness, which is constituted of SiO₂, so as to cover polysilicon film 109. Polysilicon film 111 is then deposited all over the surface of interlayer insulating film 110 so as to fill up groove 105 by the LP-CVD method.

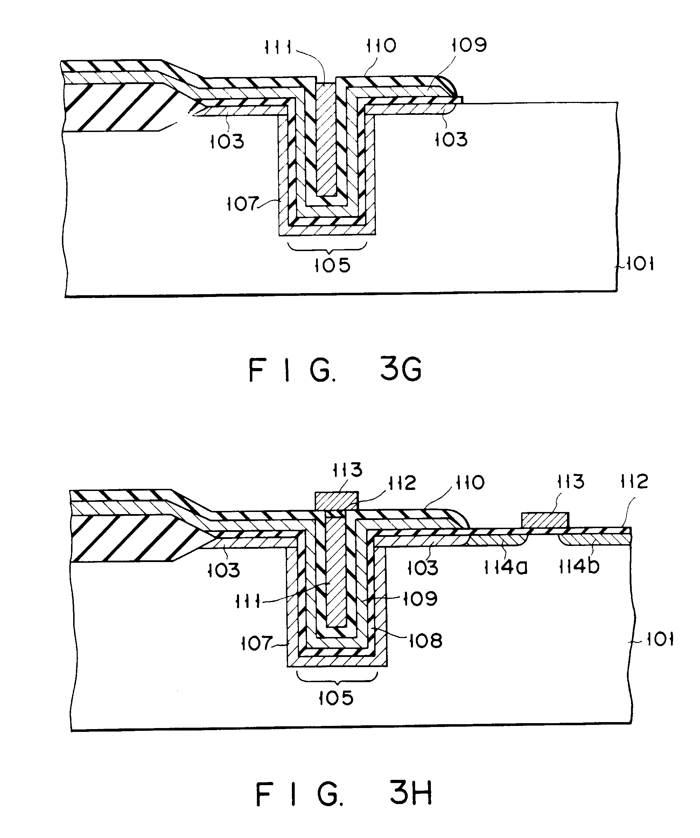

Subsequently, as shown in Fig. 3G, polysilicon layer 111 is removed by etching so that it remains only in groove 105. Oxide film 108 formed on substrate 101 is removed by the wet etching to expose the surface of substrate 101.

Fig. 3H shows the following processing. Gate oxide film 112 having a thickness of abou 20 nm (200 Å) is formed on the exposed surface of the substrate 101, and on the surface of polysilicon layer 111 which remains in groove 105. Polysilicon film 113 is deposited on oxide film 112 and it is doped with impurities. Then, polysilicon film 113 is selectively etched to form a gate electrode, and N-type diffusion layers 114a and 114b serving as a source and a drain regions, are formed by a common ion implantation technique.

As has been described in detail, according to the embodiment of the present invention, after polysilicon film 109 serving as a capacitor electrode is patterned, interlayer insulating film 110 is formed on polysilicon film 109, and then polysilicon film 111 for filling up groove 105 is formed on interlayer insulating film 110. Unlike the conventional device, therefore, the sides of polysilicon film 111 are not exposed and only the surface thereof is exposed. Since polysilicon film 111 is only oxidized from the top, it is possible to prevent a strong stress from being applied to polysilicon film 111, and to prevent the degradation of a withstanding voltage of the trench capacitor and the generation of defective crystals.

Since interlayer insulating film 110 serves as a stopper of the etching for leaving polysilicon film 111 in groove 105, it is unnecessary to form and remove a film exclusively for a stopper. The manufacturing steps can be simpler than the conventional manufacturing steps.

A pad oxide film can be formed in the lower portion of Si₃N₄ film 104A. In place of PSG film 106 serving as a diffusion source of N-type diffusion layer 107, another kind of silicate glass film containing at least N-type impurities such as an AsSG film. Further, as a film embedded in the groove 105, an insulating film such as a Si₃N₄ film can be used in place of polysilicon film 111. In place of oxide film 108 serving as a dielectric film of the capacitor, a dielectric film such as a Si₃N₄ film and a Ta₂O₅ film or a compound film of a plurality of dielectric films such as a three-layered structure of SiO₂ film, Si₃N₄ and SiO₂ film, can be used. Since an insulating film using the Si₃N₄ film or a Ta₂O₅ film allows a high dielectric constant, a larger capacitance can be achieved.

The semiconductor device having a trench capacitor according to the embodiment described above can prevent the degradation of a withstanding voltage of the trench capacitor and the generation of defective crystals, and can simplify the manufacturing steps.

## Claims

1. A method of manufacturing a semicondcutor device comprising a trench capacitor and a MOS transistor, said method comprising the steps of:
selectively etching a first area of a semiconductor substrate (101) so as to form a groove (105) therein, said first area corresponding to a region where said trench capacitor will be formed;
forming a first conductive layer (107) on the sides and the bottom of said groove (105), said first conductive layer (107) serving as an electrode of said trench capacitor;
forming an insulating layer (108) on the sides and the bottom of said groove (105) and on the upper surface of said semiconductor substrate (101), said insulating layer (108) serving as a dielectric of said trench capacitor;
forming a second conductive layer (109) on said insulating layer (108), said second conductive layer (109) serving as another electrode of said trench capacitor;
patterning said second conductive layer (109) beyond said groove (105) to form a capacitor electrode;
forming an interlayer insulating film (110) so as to cover the upper surface and the sides of said patterned capacitor electrode;
forming a buried polysilicon layer (111) on said interlayer insulating film (110) so as to fill up said groove (105);
etching said buried layer (111) so as to be kept only within said groove (105);
etching the layers formed above said semiconductor substrate (101) to expose a second area of the upper surface of said semiconductor substrate (101), said second area corresponding to a region where said MOS transistor will be formed;
forming an oxide film (112) on said buried layer (111) by thermal oxidation, and simultaneously forming a gate oxide film (112) on said exposed upper surface of semiconductor substrate (101) by the thermal oxidation;
forming a gate electrode layer (113) on said gate oxide film (112) which has been formed on said semiconductor substrate (101), and simultaneously forming said gate electrode layer (113) so as to cover said oxide film (112) which has been formed on the upper surface of said buried layer (111);
patterning said gate electrode layer (113) on said gate oxide film (112) which has been formed on said semiconductor substrate (101) to form a gate electrode; and
forming source and drain regions (114a, 114b) by ion implantation using said gate electrode layer (113) as a mask.

2. The method according to claim 1,
**characterized** in that said first conductive layer (107) includes an impurity diffusion layer.

3. The method according to claim 2,
**characterized** in that said impurity diffusion layer is formed by the steps of forming a silicate glass layer (106) containing impurities on the sides and the bottom of the groove (105) and diffusing the impurities of the silicate glass layer (106) into the semiconductor substrate (101) along the outer surface of said groove (105).

4. The method according to claim 1,
**characterized** in that said insulating layer (108) is a compound film of a plurality of dielectric films.

## Patentansprüche

1. Ein Verfahren zum Herstellen einer Halbleitervorrichtung, die einen Grabenkondensator und einen MOS Transistor einschließt, wobei das Verfahren die Schritte umfaßt:
selektives Ätzen eines ersten Bereiches eines Halbleitersubstrates (101), um darin eine Rinne (105) auszubilden, wobei dieser erste Bereich einem Bereich entspricht, wo der Grabenkondensator gebildet werden wird;
Bilden einer ersten leitfähigen Schicht (107) auf den Seiten und dem Boden der Rinne (105), wobei die erste leitfähige Schicht (107) als eine Elektrode des Grabenkondensators dient;
Bilden einer Isolierschicht (108) auf den Seiten und dem Boden der Rinne (105) und der oberen Oberfläche des Halbleitersubstrates (101), wobei die Isolierschicht (108) als Dielektrikum des Grabenkondensators dient;
Bilden einer zweiten Isolierschicht (109) auf der Isolierschicht (108), wobei die Isolierschicht (109) als eine andere Elektrode des Grabenkondensators dient;
Mustern der Isolierschicht (109) über die Rinne (105) hinaus, um eine Kondensatorelektrode zu bilden;
Bilden eines Zwischenschichtisolierfilms (110), um so die obere Oberfläche und die Seiten der gebildeten Kondensatorelektrode zu bedecken;
Bilden einer vergrabenen Polysiliziumschicht (111) auf dem Zwischenschichtisolierfilm (110), um so die Rinne (105) aufzufüllen;
Ätzen der vergrabenen Schicht (111), so daß sie nur innen in der Rinne (105) gehalten wird;
Ätzen der über dem Halbleitersubstrat (101) gebildeten Schichten, um einen zweiten Bereich der oberen Oberfläche des Halbleitersubstrates (101) freizulegen, wobei der zweite Bereich einem Bereich entspricht, wo der MOS Transistor gebildet werden wird;
Bilden eines Oxidfilms (112) auf der vergrabenen Schicht (111) durch thermische Oxidation, und gleichzeitiges Bilden eines Gate-Oxidfilms (112)auf der oberen Oberfläche des Halbleitersubstrates (101) durch die thermische Oxidation;
Bilden einer Gate-Elektrodenschicht (113) auf dem Gate-Oxidfilm (112), der auf dem Halbleitersubstrat (101) gebildet worden ist, und gleichzeitiges Bilden der Gate-Elektrodenschicht (113), um so den Oxidfilm (112), der auf der oberen Oberfläche der vergrabenen Schicht (111) gebildet worden ist, zu bedecken,;
Mustern der Eleltrodenschicht (113) auf dem Gate-Oxidfilm (112), der auf dem Halbleitersubstrat (101) gebildet wurde, um eine Gate-Elektrode zu bilden; und
Bilden von Source- und Drain-Bereichen (114a, 114b) durch Ionenimplantierung unter Verwendung der Gate-Elektrodenschicht als einer Maske.

2. Verfahren nach Anspruch 1, dadurch gekennzeichnet, daß die erste leitfähige Schicht (107) eine Verunreinigungsdiffusionsschicht einschließt.

3. Verfahren nach Anspruch 2, dadurch gekennzeichnet, daß die Verunreinigungsdiffusionsschicht gebildet wird, durch die Schritte des Bildens einer Glassilikatschicht (106), die Verunreinigungen auf den Seiten und dem Boden der Rinne (105) enthält, und diffundieren der Verunreinigungen der Glassilikatschicht (106) entlang der äußeren Oberfläche der Rinne (105) in das Halbleitersubstrat (101) hinein.

4. Verfahren nach Anspruch 1, dadurch gekennzeichnet, daß die Isolierschicht (108) ein Mischfilm aus einer Vielzahl von dielektrischen Filmen ist.

## Revendications

1. Procédé de fabrication d'un dispositif à semiconducteurs comportant un condensateur sous forme de tranchée et un transistor MOS, comportant les étapes consistant à :
graver sélectivement une première surface d'un substrat semiconducteur (101) de manière à y former une gorge (105), ladite première surface correspondant à une région dans laquelle ledit condensateur sous forme de tranchée sera formé;
former une première couche conductrice (107) sur les côtés et le fond de ladite gorge (105), ladite première couche conductrice (107) servant d'électrode dudit condensateur sous forme de tranchée;
former une couche isolante (108) sur les côtés et le fond de ladite gorge (105) et sur la surface supérieure dudit substrat semiconducteur (101), ladite couche isolante servant de diélectrique dudit condensateur sous forme de tranchée;
former une seconde couche conductrice (109) sur ladite couche isolante (108), ladite seconde couche conductrice (109) servant d'autres électrodes dudit condensateur sous forme de tranchée;
configurer ladite seconde couche conductrice (109) au-delà de ladite gorge (105) pour former une électrode de condensateur;
former une pellicule d'isolement entre couches (110) de manière à recouvrir la surface supérieure et les côtés de ladite électrode de condensateur configurée;
former une couche de silicium polycristallin enterrée (111) sur ladite pellicule d'isolement entre couches (110) de manière à combler ladite gorge (105);
graver ladite couche enterrée (111) de manière à la laisser subsister uniquement à l'intérieur de ladite gorge (105);
graver les couches formées au-dessus dudit substrat semiconducteur (101) pour mettre à nu une seconde région de la surface supérieure dudit substrat semiconducteur (101), ladite seconde surface correspondant à une région dans laquelle ledit transistor MOS sera formé;
former une pellicule d'oxyde (112) sur ladite couche enterrée (111) par oxydation thermique, et former simultanément une pellicule d'oxyde de grille (112) sur ladite surface supérieure à nu du substrat semiconducteur (101) par oxydation thermique;
former une couche d'électrode de grille (113) sur ladite pellicule d'oxyde de grille (112) qui a été formée sur ledit substrat semiconducteur (101), et simultanément former ladite couche d'électrode de grille (113) de manière à recouvrir ladite pellicule d'oxyde (112) qui a été formée sur la surface supérieure de ladite couche enterrée (111);
configurer ladite couche d'électrode de grille (113) sur ladite pellicule d'oxyde de grille (112) qui a été formée sur ledit substrat semiconducteur (101) pour former une électrode de grille; et
former des régions de source et de drain (114a, 114b) par implantation ionique en utilisant ladite couche d'électrode de grille (113) comme masque.

2. Procédé selon la revendication 1, caractérisé en ce que ladite première couche conductrice (107) comprend une couche de diffusion d'impuretés.

3. Procédé selon la revendication 2, caractérisé en ce que ladite couche de diffusion d'impuretés est formée par les étapes de formation d'une couche de verre au silicate (106) contenant des impuretés sur les côtés et le fond de la gorge (205) et la diffusion des impuretés de la couche de verre au silicate (106) dans le substrat semiconducteur (101) le long de la surface extérieure de ladite gorge (105).

4. Procédé selon la revendication 1, caractérisé en ce que ladite couche d'isolement (108) est une pellicule composite d'une pluralité de pellicules diélectriques.
